## Europäisches Patentamt
## European Patent Office
## Office européen des brevets

(11) Veröffentlichungsnummer: **0 232 767**
**A2**

# EUROPÄISCHE PATENTANMELDUNG

(21) Anmeldenummer: **87100886.8**

(22) Anmeldetag: **23.01.87**

(51) Int. Cl.⁴: **C 03 C 8/02**, C 03 C 8/24

(30) Priorität: **12.02.86 US 828938**

(43) Veröffentlichungstag der Anmeldung: **19.08.87**
**Patentblatt 87/34**

(84) Benannte Vertragsstaaten: **DE FR GB**

(71) Anmelder: **W.C. Heraeus GmbH, Heraeusstrasse 12 - 14, D-6450 Hanau / Main (DE)**

(72) Erfinder: **Hankey, Dana L., Dr., 102 Briddle Drive, Exton, PA 19341 (US)**
Erfinder: **Sutterlin, Robert Charles, 2235 Hillside Lane, Aston, PA 19014 (US)**

(74) Vertreter: **Heinen, Gerhard, Dr., W.C. Heraeus GmbH Zentralbereich Patente und Lizenzen Heraeusstrasse 12-14, D-6450 Hanau (DE)**

(54) **Überglasurpaste.**

(57) Eine Überglasurpaste aus
55–70% eines Glasversatzes und
30–45% eines organischen Bindemittels wird beschrieben.

Die Überglasurpaste ist für die Herstellung stabiler integrierter Mehrschichtschaltkreise auf Substratmaterialien, insbesondere Aluminiumoxid, geeignet.

EP 0 232 767 A2

W.C.Heraeus GmbH

Patentanmeldung

ÜBERGLASURPASTE

Die vorliegende Erfindung betrifft Dickfilm-Überglasurpasten und ihre Verwendung als Schutzschicht für elektrische Schaltkreisstrukturen, insbesondere Mehrschichtanordnungen und Widerstandsnetzwerke auf Keramik-, vorzugsweise Aluminiumoxid-Substraten.

Die Verwendung von spezialisierten Pastenzusammensetzungen, um Dickfilme zu bilden, die bei der Konstruktion von integrierten Mehrschichtschaltkreisstrukturen auf geeigneten Substraten verschiedene Funktionen haben, ist in der Technik bekannt. Eine derartige Technologie ist für die Fertigung sehr dichter Mehrschichtschaltkreismuster auf verschiedenen Substraten für eine breite Auswahl von Anwendungen in der Elektronikindustrie von steigendem Interesse.

U.S.P. 4,401,709 beschreibt eine Dickfilm-Überglasurpaste, die aus 60 - 90 % eines Glaspulvers und 8 - 35 % eines organischen Bindemittels besteht. Das Glaspulver des U.S.P. 4,401,709 wird beschrieben, daß es (a) 58 - 66 % Bleioxid, (b) 12 - 20 % eines Modifizierungsmittels, bestehend aus (I) 2 - 6 % Cadmiumoxid, (II) 4 - 8 % Zinkoxid, (III) 0,1 - 3 % Bariumoxid und (IV) 0,1 - 3 % Antimontrioxid, und (c) 20 - 27 % einer glasbildenden Komponente, bestehend aus (I) 0,1 - 2 % Aluminiumoxid, (II) 14 - 20 % Bortrioxid und (III) 1 - 7 % Siliziumdioxid, enthält.

Überglasurpasten werden verwendet, um dem Teil der Filme unterschiedlicher Funktionen, vorwiegend Widerstands- und Leiterfilme, mechanischen Schutz und Schutz gegen Umwelteinflüsse zu geben, der nicht anderweitig, z. B. durch Komponenten, bedeckt ist.

Es ist allgemein anerkannt, daß Überglasurfilme, die mit Pasten gebildet werden, wie sie hier beschrieben sind, folgendes besitzen sollten: Einen thermischen Ausdehnungskoeffizienten, der angemessen nahe bei dem des verwendeten Sustrats liegt, auch

1

angemessen nahe bei dem der verschiedenen funktionalen Filme, die den Schaltkreis bilden, gute mechanische Festigkeit und am wichtigsten gute chemische Kompatibilität mit den darunterliegenden Leiter- und Widerstandsfilmen.

Überglasurpasten enthalten üblicherweise Bleioxid, um die Einbrenntemperatur wesentlich unter diejenige der funktionalen Filme zu senken, die sich bereits auf dem Substrat befinden. Der inhärente Nachteil eines hohen Bleigehaltes ist jedoch, daß eine Erhöhung des Bleigehaltes der Paste auch die Wahrscheinlichkeit der chemischen Reduktion der Oberfläche des Bleioxids erhöht, wenn es in einer inerten Atmosphäre, z. B. in Stickstoff, eingebrannt wird. Eine Reduktion der Oberfläche des Bleioxids wirkt störend auf das Sintern und vermindert das Fließen der Paste. Dieses letztere Problem ist das Ernstere, da eine in Stickstoff eingebrannte Paste so fließen muß, als ob sie an Luft eingebrannt würde. Die Erfindung der vorliegenden Anmeldung schließt grundsätzlich eine Überglasurzusammensetzung mit einem niedrigen Bleigehalt (<3 Gewichtsprozent) ein.

Es ist auch anzuerkennen, daß eine Überglasurpaste nicht in einem bedeutenden Ausmaß mit irgendeinem Teil des Schaltkreises auf dem Substrat reagieren darf. Dies gilt insbesondere für Widerstände, da eine solche Reaktion normalerweise eine nachteilige Wirkung auf die Stabilität und die Widerstandswerte der Widerstände hat. Um akzeptierbar zu sein, sollte ein Überglasurfilm den Wert eines Widerstandes um nicht mehr als fünf Prozent verändern. Eine Änderung von plus oder minus zwei Prozent ist der normale industrielle Standard. Filme, die von den neuen Überglasurpasten dieser Erfindung gebildet werden, liegen leicht innerhalb dieses Standard-Annahmekriteriums.

Obwohl in einigen Fällen Überglasurpasten aus Gründen der Wirtschaftlichkeit gleichzeitig mit den darunterliegenden Leitern und Widerständen eingebrannt werden, werden sie im Allgemeinen unabhängig bei Spitzentemperaturen eingebrannt, die wesentlich unter der Einbrenntemperatur der Leiter- und Widerstandsfilme liegen. Einige konventionelle Pasten können nur in Stickstoff oder nur an Luft eingebrannt werden.

Es ist ein Zweck der vorliegenden Erfindung, eine Überglasurformulierung mit einem relativ niedrigen Bleigehalt zu erhalten, z. B. von 3 Gewichtsprozent oder weniger.

Es ist ein anderer Zweck der vorliegenden Erfindung, Überglasurpasten für die Bildung von Filmen zu erhalten, die den industriellen Standards für Widerstandswerte von Widerständen entsprechen.

Es ist ein weiterer Zweck der vorliegenden Erfindung, Überglasurpasten zu erhalten, die sowohl an Luft als auch in inerten Atmosphären, z. B. in Stickstoff, eingebrannt werden können.

Es ist noch ein anderer Zweck der vorliegenden Erfindung, Überglasurpasten zu erhalten, die in der Lage sind, bei Spitzentemperaturen von 590°C - 640°C eingebrannt zu werden.

Die obigen Zwecke und andere Zwecke und Vorteile werden von der vorliegenden Erfindung erfüllt.

Die Dickfilm-Überglasurpasten in Übereinstimmung mit dieser Erfindung umfassen (a) ein Barium- und/oder Strontiumoxide enthaltendes Glas, (b) eine Bor- oder Borosilikatglas-bildende Komponente, (c) Dotierungsmittel, z. B. Zink, Lithium, Kalium, Natrium, Blei und Vanadium, (d) wahlweise Modifizierungskomponenten, z. B. Chrom, Zirkonium, Aluminium und Titan, (e) wahlweise färbende Oxide, z. B. Chrom, Kobalt und Nickel, und (f) ein passendes organisches Bindemittel.

Die vorliegende Erfindung betrifft eine Überglasurpaste, bestehend aus

(a) 55 - 70 % eines Glasversatzes, basierend auf dem Gesamtgewicht der Überglasurpaste, bestehend aus

(1) 15 - 43 %, basierend auf dem Gesamtgewicht des Glasversatzes, einer Hauptglaskomponente

3

ausgewählt aus der Gruppe, bestehend aus BaO, SrO und SrO + BaO,

(2) einer glasbildenden Komponente, die

$34 - 45 \% B_2O_3$ und

$0 - 6 \% SiO_2$ enthält,

(3) $0 - 2 \%$, basierend auf dem Gesamtgewichts des Glasversatzes, eines Färbemittels, ausgewählt aus der Gruppe, bestehend aus $Cr_2O_3$, CoO und NiO,

(4) $7 - 20 \%$, basierend auf dem Gesamtgewicht des Glasversatzes, eines Wärmeausdehnungs-Modifizierungsmittels, ausgewählt aus der Gruppe bestehend aus ZnO, $Al_2O_3$, $TiO_2$ und Gemischen daraus, und

(5) $1 - 5 \%$, basierend auf dem Gesamtgewicht des Glasversatzes, eines Dotierungsmittels, das eine oder mehrere der folgenden Substanzen enthält:

| $ZnF_2$ | $0 - 5 \%$ | |
| $Li_2O$ | $0 - 2 \%$ | |
| $Na_2O$ | $0 - 2 \%$ | |
| $K_2O$ | $0 - 2 \%$ | |
| LiF | $0 - 2 \%$ | |
| NaF | $0 - 2 \%$ | |
| KF | $0 - 2 \%$ | |
| $BaF_2$ | $0 - 2 \%$ | |
| $Na_2SiF_6$ | $0 - 2 \%$ | |
| PbO | $0 - 3 \%$ | |
| $V_2O_5$ | $0 - 2 \%$ | |
| $Bi_2O_3$ | $0 - 2 \%$ | und |

(b) $30 - 40 \%$ eines organischen Bindemittels, basierend auf dem Gesamtgewicht der Überglasurpaste.

Die vorliegende Erfindung betrifft eine neue Überglasurpaste, die für die Verwendung als Schutzschicht für elektrische Mehrschichtschaltkreisstrukturen geeignet ist.

4

Die Überglasurpaste der vorliegenden Erfindung besteht aus

(a) 55 - 70 %, vorzugsweise 60 - 70 %, basierend auf dem Gesamtgewicht der Überglasurpaste, eines Glasversatzes und

(b) 30 - 45 %, vorzugsweise 33 - 37 %, basierend auf dem Gesamtgewicht der Überglasurpaste, eines organischen Bindemittels.

Der Glasversatz der vorliegenden Erfindung besteht aus

(a) 15 - 43 %, vorzugsweise 20 - 38 %, basierend auf dem Gesamtgewicht des Glasversatzes, einer Hauptglaskomponente ausgewählt aus der Gruppe von SrO, BaO und SrO + BaO;

(b) einer glasbildenden Komponente, die 34 - 45 %, vorzugsweise 36 - 42 % $B_2O_3$, basierend auf dem Gesamtgewicht des Glasversatzes, und

0 - 6 %, vorzugsweise 1 - 4 % Siliziumoxid ($SiO_2$), basierend auf dem Gesamtgewicht des Glasversatzes, enthält;

(c) 0 - 2 %, vorzugweise 0,5 - 2 %, basierend auf dem Gesamtgewicht des Glasversatzes, eines Färbemittels (Farbgeber), das aus der Gruppe von $Cr_2O_3$, CoO und NiO ausgewählt ist, vorzugsweise $Cr_2O_3$ (das $Cr_2O_3$ kann auch als Modifizierungsmittel fungieren);

(d) 7 - 20 %, vorzugsweise 15 - 20 %, basierend auf dem Gesamtgewicht des Glasversatzes, eines Wärmeausdehnungs-Modifizierungsmittels, das aus der Gruppe von ZnO, $Al_2O_3$ und $TiO_2$ und Gemischen davon ausgewählt ist, vorzugsweise ZnO; und

(e) 1 - 7 %, vorzugsweise 4 - 6 % eines Dotierungsmittels, welches eine oder mehrere der folgenden Substanzen enthält:

|  | Einsatzbereich | bevorzugter Bereich |
|---|---|---|
| $ZnF_2$ | 0 - 5 % | 0,5 - 2 % |
| $Li_2O$ | 0 - 2 % | 0,25 - 1,5 % |
| $Na_2O$ | 0 - 2 % | 0,25 - 1,5 % |
| $K_2O$ | 0 - 2 % | 0,25 - 1,5 % |
| LiF | 0 - 2 % | 0,25 - 1,5 % |
| NaF | 0 - 2 % | 0,25 - 1,5 % |
| KF | 0 - 2 % | 0,25 - 1,5 % |
| $BaF_2$ | 0 - 2 % | 0,25 - 1,5 % |
| $Na_2SiF_6$ | 0 - 2 % | 1 - 2 % |
| PbO | 0 - 3 % | 0 - 2 % |
| $V_2O_5$ | 0 - 2 % | 0,5 - 2 % |
| $Bi_2O_3$ | 0 - 2 % | 0,5 - 2 % |

Das Glas wird hergestellt, indem man die Glaskomponenten in der Form von konventionellen Keramikoxid-, Karbonat- Fluorid- oder Silikofluoridrohmaterialien in einem V - Mischer zusammenmischt. Geeignete Rohmaterialien schließen ein: Oxide, Karbonate und/oder Fluoride der Gruppen I A und II A, Bleioxid oder Vanadiumoxid. Das Rohmaterialgemisch kann in einen Glasschmelzofen bei Temperaturen zwischen 1.000°C und 1.300°C chargiert werden, um eine glasartige Schmelze herzustellen. Das Glas wird anschließend durch Abschrecken in Wasser gefrittet. Die Fritte wird mittels konventioneller Mahlmethoden (Kugelmühle) zu Pulver gemahlen. Das Ergebnis dieses Prozesses ist ein homogenes Glaspulver.

Dem Glaspulver werden passende Färbe- und/oder Modifizierungsmittel zugesetzt und diese durch Wiederholen des vorerwähnten Mahlprozesses sorgfältig vermischt.

Das Modifizierungsmittel kann ein Oxid wie $Cr_2O_3$, $TiO_2$, $ZrO_2$, $Al_2O_3$ und Gemische davon sein. Das bevorzugte Oxid ist $Cr_2O_3$, das sowohl dazu verwendet werden kann, den Schmelzpunkt des Glases zu modifizieren, als auch, um ihm eine grüne Farbe zu verleihen. Ein zweites bevorzugtes Modifizierungsmittel ist $Cr_2O_3$ plus $TiO_2$.
Die Pastenformulierung dieser Erfindung kann auch eine geringe Menge eines konventionellen färbenden Oxids wie Oxide von Chrom, Kobalt, Nickel und dergleichen enthalten.

Das Gemisch aus Glasfritte, Färbemittel und Modifizierungsmittel wird mit einem organischen Bindemittel vereinigt, um eine Paste mit 60 - 70 Gew.% Feststoffen zu erzeugen. Die Glas/Oxid/Binder-Mischung wird dann auf einem Walzenstuhl zu einer homogenen Paste verarbeitet, die auf jede beliebige konventionelle Art wie z. B. durch Siebdruck, Pinseln oder Sprühen aufgetragen werden kann, wobei Siebdruck bevorzugt ist.

Die Überglasurpasten dieser Erfindung werden allgemein bei Spitzentemperaturen von 590°C - 620°C eingebrannt und sind einzigartig in der Weise, daß man sie sowohl an Luft als auch vorzugsweise in inerten Atmosphären, z. B. in Stickstoff, einbrennen kann. Da die meisten konventionellen Pasten nur in einer dieser Atmosphären einbrennbar sind, ist die Fähigkeit der Pasten dieser Erfindung, in jeder dieser Atmosphären einbrennbar zu sein, besonders vorteilhaft für die Herstellung hoch komplexer Mehrschichtschaltkreise.

Ein organisches Bindemittel ist ein Medium, das sich bei einer relativ niedrigen Temperatur (etwa 400°C - 500°C) verflüchtigt, ohne eine Reduktion der anderen Pastenkomponenten zu verursachen. Ein organischer Binder wirkt als Übertragungsmedium für das Siebdrucken. Ein organisches Bindemittel zur Verwendung in der vorliegenden Erfindung ist vorzugsweise ein Harz, z. B. ein Acrylesterharz, vorzugsweise ein Isobutylmethacrylat, und ein Lösungsmittel, z. B. ein Alkohol, vorzugsweise Tridecylalkohol ("TDA"). Das Harz kann ein beliebiges Polymer sein, das bei oder unter 400°C in Stickstoff depolymerisiert. Andere anwendbare Lösungsmittel sind Terpineol oder "TEXANOL" von Eastman Kodak, Rochester, New York, U.S.A. Das in der vorliegenden Erfindung zu verwendende Lösungsmittel kann ein beliebiges Lösungsmittel sein, welches das betreffende Harz auflöst und einen geeigneten Dampfdruck aufweist, der mit dem nachfolgenden Anpasten und Siebdrucken verträglich ist. In einer bevorzugten Anwendungsform besteht das organische Bindemittel aus 10 - 40 %

7

Isobutylmethacrylat und 90 - 60 % TDA.

Die Überglasurpasten dieser Erfindung werden auf das Substrat, vorzugsweise Aluminiumoxid, aufgetragen, um einen Teil von elektronischen Einschicht- und Mehrschichtenschaltkreisen zu überlagern, die bereits aufgetragen worden sind. Die Pasten können auf jede konventionelle Art aufgetragen werden, wie z. B. durch Trocknen, Siebdrucken, Pinseln, Sprühen und dergleichen, vorzugsweise durch Siebdrucken. Allgemein würden eine oder zwei Schichten Überglasur verwendet. Für Widerstände würde allgemein eine Schicht benutzt werden. Für hermetische Verpackungen würden eine oder zwei Schichten angewendet werden. Die zweite Schicht würde dazu dienen, die Möglichkeit von Pinholes zu minimieren und einen maximalen Schutz zu geben. Die Schichten werden einzeln getrocknet und eingebrannt. Jede Pastenschicht wird an Luft 15 Minuten lang bei 125°C - 150°C getrocknet. Der resultierende Film kann dann bei einer Spitzentemperatur von 590°C - 640°C, vorzugsweise bei 600°C - 620°C, 2 bis 3 Minuten lang entweder an Luft oder in Stickstoff eingebrannt werden. Die so erhaltenen Überglasurfilme haben ausgezeichnete mechanische Festigkeit, gute thermische Stabilität und einen minimalen Effekt auf die Flächenwiderstandswerte der Widerstände in dem Schaltkreis. Die Überglasurfilme der vorliegenden Erfindung haben eine ausgeprägte Fähigkeit gezeigt, die Widerstandsdrift durch Abrieb, Tauchen in Lot und einem Ausgesetztsein von Hitze und Feuchtigkeit zu verringern.

Die folgenden Beispiele beschreiben diese Erfindung weiter, wobei es wohlverstanden ist, daß es in keiner Weise beabsichtigt ist, die Erfindung auf die hierin beschriebenen Einzelheiten zu beschränken.

Beispiel 1

A. Herstellung einer Glasfritte der folgenden Zusammensetzung:

|  | Gew. % |
|---|---|
| BaO | 34,25 |
| $B_2O_3$ | 39,25 |

8

|  | Gew. % |
|---|---|
| ZnO | 19,57 |
| $Cr_2O_3$ | 0,98 |
| $ZnF_2$ | 0,98 |
| $Li_2O$ | 1,17 |
| LiF | 0,98 |
| PbO | 1,56 |
| $V_2O_5$ | 1,27 |

Die folgenden Pulver wurden vereinigt und bei 1.000°C - 1.100°C unter Bildung einer homogenen Glasschmelze geschmolzen:

|  |  | Gewicht in g |
|---|---|---|
| $BaCO_3$ | Fisher (King of Prussia, PA, U.S.A.) Certified A.C.S. precipitated B-30 | 1351,40 |
| $B_2O_3$ | Fisher purified A-76 | 1203,30 |
| ZnO | Fisher certified A.C.S. (dry process) Z52 | 600,00 |
| $Cr_2O_3$ | Alfa (Danvers, MA, U.S.A.) 99% pure -325 mesh | 30,00 |
| $ZnF_2$ | Alfa 99% pure anhydrous | 30,00 |
| $Li_2CO_3$ | Fisher certified A.C.S. 99,4% pure L-119 | 89,20 |
| LiF | Alfa 99% | 30,00 |
| PbO | Fisher Mono-Yellow certified L-71 | 47,77 |
| $V_2O_5$ | Fisher technical V-5 | 38,10 |

Von Barium und Lithium wurden Karbonate benutzt.

Alternativ hätten Oxide verwendet werden können. Die entsprechenden Umrechnungsfaktoren waren 1,287 für Bariumoxid zu Bariumkarbonat und 2,477 für Lithiumoxid zu Lithiumkarbonat.

Die Pulver wurden zwei Stunden lang trocken in einem V - Mischer gemischt. Das Pulver wurde dann in Mullittiegel überführt.

Das Fritten wurde folgendermaßen durchgeführt:

9

a) Die Mullittiegel mit dem Pulver wurden 30 Minuten lang bei 600°C vorgeheizt, ehe man die Temperatur auf 1.050°C ansteigen ließ (verflossene Zeit 2 Stunden in einem Lindbergofen 51894, Maximaltemperatur 1.100°C). Nach 15 Minuten Verweilzeit bei 1.050°C wurde vollständige Solvatisierung beobachtet,und das Glas wurde durch Abschrecken in Wasser gefrittet.

b) Kugelmahlvorgang

Nach dem Dekantieren des entionisierten Wassers wurde die Fritte in eine keramische Kugelmühle mit Mahlkugeln aus Aluminiumoxid in Isopropanol (IPA) eingebracht. Die Fritte wurde auf die richtige Partikelgröße kugelgemahlen und durch ein 200 mesh Sieb naß gesiebt. Das Material wurde in Metallpfannen gegeben und über Nacht in einem Trockner mit Luftumwälzung getrocknet. Das Material wurde dann für mehrere Stunden in einen Ofen bei 150°C gebracht, um jegliches Wasser abzudampfen, das hätte vorhanden gewesen sein können.

Modifizierungsmittel wurde wie folgt zugesetzt:

3,75% $Cr_2O_3$ (Alfa - 325 mesh) wurde dem Frittenpulver der oben beschriebenen Zusammensetzung zugesetzt und dann unter Standardbedingungen weitere 24 Stunden gemahlen.

Analyse der modifizierten Frittenpulverzusammensetzung:

I) TMA (Thermometrische Analyse): 515°C $\pm$ 5°C

II) Sedigraph: 90% 6,9 µm

50% 3,6 µm

10% 1,5 µm

B. Herstellung einer Paste

Das Glas/Modifizierungsmittel-Gemisch wurde mit einer passenden Menge Acrylbindemittel vereinigt. Das Bindemittel ist eine Mischung von B-67 "acryloid"-Harz (ein Isobutylmethacrylat,hergestellt von Rohm & Haas, Philadelphia, Pennsylvania, U.S.A.) und TDA (Tridecylalkohol).

Glas und Bindemittel wurden in einem Hobart-Mischer gemischt, bis sie für das Anpasten auf dem Walzenstuhl geeignet waren. Die Paste wurde dann auf dem Walzenstuhl dispergiert, bis sie glatt war (Kornfeinheit "f.o.g." <10 µm).

10

Die % Feststoffe und die Viskosität wurden dann wie folgt bestimmt:

% Feststoffe          65% ± 1,0%

Viskosität        40 kcp ± 5 kcp Ferranti Shirley, kleiner Kegelstumpf, 240 Sek.

        Durchlauf, Federkonstante 2,0

Das Bindemittel hatte folgende Zusammensetzung:

|  | Gew.% |
|---|---|
| B67 "ACRYLOID" | 35% |
| Tridecylalkohol (TDA) | 65% |

Die Viskosität des Bindemittels wurde unter Verwendung eines Ferranti-Shirley Viskosimeters bestimmt.

Viskosität 15 kcp        Ferranti Shirley, mittlerer Kegelstumpf, 240 Sek. Durchlauf

Die resultierende Überglasurpaste kann als Widerstands-Schutzüberglasur eingesetzt werden, die zur Verarbeitung bei 600°C - 610°C in Stickstoff mit einer minimalen Änderung des Widerstandes konzipiert ist, und hat die folgenden Eigenschaften:

Viskosität:        40 kcp, Ferranti-Shirley

Drucken:        Sieb 325 mesh, 7-8 µm eingebrannt

Trocknen:        konventionell oder Infrarot (IR) Bandtrockner trocknen bei 150°C

| Widerstand (Ohm/□) | % Widerstandsänderung |
|---|---|
| 500 | +5 |
| 1K | +4 |
| 10K | +3 |
| 100K | +6 |
| 1M | +7 |

11

## Beispiele 2 bis 11

Glasfritten der folgenden Zusammensetzungen wurden wie oben im Beispiel 1 beschrieben hergestellt:

| Komponente | Beispiel Nr. | | | | | | | | | |
|---|---|---|---|---|---|---|---|---|---|---|
| | 2 | 3 | 4 | 5 | 6 | 7 | 8 | 9 | 10 | 11 |
| $SrO$ | 37,18 | -- | -- | -- | -- | -- | -- | -- | 17,15 | -- |
| $BaO$ | -- | 37,15 | 37,15 | 33,93 | 33,93 | 34,93 | 33,27 | 34,25 | 17,15 | 31,25 |
| $B_2O_3$ | 39,14 | 39,10 | 39,10 | 39,92 | 39,92 | 39,92 | 39,14 | 39,53 | 39,14 | 36,25 |
| $ZnO$ | 19,57 | 19,55 | 19,55 | 18,96 | 18,46 | 17,96 | 19,57 | 19,57 | 19,57 | 19,57 |
| $Cr_2O_3$ | 0,98 | 0,98 | 0,98 | 0,50 | 0,50 | 2,00 | 0,49 | 0,98 | 0,98 | 0,98 |
| $ZnF_2$ | 0,98 | 1,47 | 0,98 | -- | 1,00 | 1,00 | -- | 0,98 | 0,98 | 0,98 |
| $Li_2O$ | 1,17 | 1,76 | 1,17 | 1,20 | 1,20 | 1,20 | 1,17 | 1,17 | 1,17 | 1,17 |
| $LiF$ | 0,98 | -- | 0,98 | -- | 1,00 | 1,00 | 0,98 | 0,98 | 0,98 | 0,98 |
| $Bi_2O_3$ | -- | -- | -- | 2,00 | 2,00 | -- | 1,96 | -- | -- | -- |
| $PbO$ | -- | -- | -- | 2,00 | 2,00 | 2,00 | 1,96 | 2,55 | 1,56 | 1,56 |
| $V_2O_5$ | -- | -- | -- | -- | -- | -- | -- | -- | 1,27 | 1,27 |
| $BaF_2$ | -- | -- | -- | 1,5 | -- | -- | 1,47 | -- | -- | -- |
| $SiO_2$ | -- | -- | -- | -- | -- | -- | -- | -- | -- | 6,00 |

Die Eigenschaften der obigen Gläser waren wie folgt:

|  | Erweichungsbereich, °C | Behandlungstemperatur, °C |
|---|---|---|
| Beispiel 2: | 525-540 | 610 |
| Beispiel 3: | 530-550 | 620 |
| Beispiel 4: | 525-540 | 615 |
| Beispiel 5: | 540-560 | 610 |
| Beispiel 6: | 520-540 | 610 |
| Beispiel 7: | 520-540 | 610 |
| Beispiel 8: | 530-550 | 610 |
| Beispiel 9: | 530-550 | 610 |
| Beispiel 10: | 525-540 | 610 |
| Beispiel 11: | 535-555 | 620 |

Das $SiO_2$ in Beispiel 11 wurde von Fisher bezogen
(King of Prussia, PA, U.S.A.), floated powder, S153

0 232 767

W.C.Heraeus GmbH

Patentanmeldung

ÜBERGLASURPASTE

PATENTANSPRÜCHE

1. Eine Überglasurpaste, enthaltend

(a) 55-70% eines Glasversatzes, der enthält

(1) 15-43% einer Hauptglaskomponente, ausgewählt aus der Gruppe, bestehend aus BaO, SrO und SrO + BaO,

(2) eine glasbildende Komponente, die

$34\text{-}45\% \ B_2O_3$ und

$0\text{-} \ 6\% \ SiO_2$ enthält,

(3) 0-2% eines Färbemittels, ausgewählt aus der Gruppe, bestehend aus $Cr_2O_3$, CoO und NiO,

(4) 7-20% eines Wärmeausdehnungsmodifizierungsmittels, ausgewählt aus der Gruppe, bestehend aus ZnO, $Al_2O_3$, $TiO_2$ und Gemischen daraus, und

(5) 1-7% eines Dotierungsmittels, bestehend aus einer oder mehreren der folgenden Substanzen:

| | |
|---|---|
| $ZnF_2$ | 0 - 5% |
| $Li_2O$ | 0 - 2% |
| $Na_2O$ | 0 - 2% |
| $K_2O$ | 0 - 2% |
| LiF | 0 - 2% |
| NaF | 0 - 2% |
| KF | 0 - 2% |
| $BaF_2$ | 0 - 2% |
| $Na_2SiF_6$ | 0 - 2% |
| PbO | 0 - 3% |
| $V_2O_5$ | 0 - 2% und |
| $Bi_2O_3$ | 0 - 2% |

(b) 30-45% eines organischen Bindemittels.

2. Überglasurpaste nach Anspruch 1, dadurch gekennzeichnet, daß der Glasversatz in einer Menge von 60-70% enthalten ist.

3. Überglasurpaste nach Anspruch 1, dadurch gekennzeichnet, daß das Modifizierungsmittel in einer Menge von 15-20% enthalten ist.

4. Überglasurpaste nach Anspruch 1, dadurch gekennzeichnet, daß die Hauptglaskomponente in einer Menge von 20-38% enthalten ist.

5. Überglasurpaste nach Anspruch 1, dadurch gekennzeichnet, daß das $B_2O_3$ in einer Menge von 36-42% enthalten ist.

6. Überglasurpaste nach Anspruch 1, dadurch gekennzeichnet, daß das Färbemittel in einer Menge von 0,5-2% enthalten ist.

7. Überglasurpaste nach Anspruch 1, dadurch gekennzeichnet, daß das $SiO_2$ in einer Menge von 1-4% enthalten ist.

8. Überglasurpaste nach Anspruch 1, dadurch gekennzeichnet, daß das Färbemittel $Cr_2O_3$ ist.

9. Überglasurpaste nach Anspruch 1, dadurch gekennzeichnet, daß das Modifizierungsmittel $ZnO$ ist.

10. Überglasurpaste nach Anspruch 1, dadurch gekennzeichnet, daß das organische Bindemittel in einer Menge von 33-37% enthalten ist.

2

11. Überglasurpaste nach Anspruch 1, dadurch gekennzeichnet, daß das Dotierungsmittel eine oder mehrere der folgenden Substanzen enthält:

$$0,5 - 2 \ \% \ ZnF_2$$
$$0,25 - 1,5 \ \% \ Li_2O$$
$$0,25 - 1,5 \ \% \ Na_2O$$
$$0,25 - 1,5 \ \% \ K_2O$$
$$0,25 - 1,5 \ \% \ LiF$$
$$0,25 - 1,5 \ \% \ NaF$$
$$0,25 \ \_ \ 1,5 \ \% \ KF$$
$$0,25 - 1,5 \ \% \ BaF_2$$
$$1 \ - 2 \ \% \ Na_2SiF_6$$
$$0 \ - 2 \ \% \ PbO$$
$$0,5 - 2 \ \% \ V_2O_5 \ \text{und}$$
$$0,5 - 2 \ \% \ Bi_2O_3.$$

12. Überglasurpaste nach Anspruch 1, dadurch gekennzeichnet, daß das organische Bindemittel ein Harz und ein Lösungsmittel enthält.

13. Überglasurpaste nach Anspruch 12, dadurch gekennzeichnet, daß das Harz Isobutylmethacrylat ist.

14. Überglasurpaste nach Anspruch 12, dadurch gekennzeichnet, daß das Lösungsmittel ein Alkohol ist.

15. Überglasurpaste nach Anspruch 14, dadurch gekennzeichnet, daß der Alkohol Tridecylalkohol ist.

16. Überglasurpaste nach Anspruch 1, dadurch gekennzeichnet, daß das Dotierungsmittel in einer Menge von 4-6% enthalten ist.

17. Verwendung einer Überglasurpaste nach einem der Ansprüche 1-16 als Schutzschicht für elektrische Schaltkreisstrukturen.